# EUROPEAN PATENT SPECIFICATION

(11) **EP 2 609 628 B1**
(45) Date of publication and mention of the grant of the patent: **11.05.2016**
(21) Application number: 11767087.7
(22) Date of filing: 24.08.2011
(51) Int. Cl.: H01L 31/0224, H01L 31/05, H01L 31/18, H01L 31/0216

(54) **PHOTOVOLTAIC DEVICE AND MODULE WITH IMPROVED PASSIVATION AND A METHOD OF MANUFACTURING.**
PV-ELEMENT UND MODUL MIT VERBESSERTER PASSIVIERUNG UND HERSTELLUNGSVERFAHREN DAFÜR
DISPOSITIF PHOTOVOLTAÏQUE ET MODULE AYANT UNE PASSIVATION AMÉLIORÉE ET PROCÉDÉ DE FABRICATION

(30) Priority: 24.08.2010 NL 2005261
(43) Date of publication of application: 03.07.2013
(73) Proprietor: Energy Research Centre of The Netherlands, 1755 LE Petten (NL)
(72) Inventor: JANSSEN, Lars, NL-6422 RL Heerlen (NL); KOOPMANN, Jonas, NL-6422 RL Heerlen (NL); VAN DEN DONKER, Menno Nicolaas, NL-6422 RL Heerlen (NL); AGRICOLA, Franciscus, Theodorus, NL-6422 RL Heerlen (NL)
(74) Representative: Nederlandsch Octrooibureau
(86) International application number: PCT/NL2011/000060
(87) International publication number: WO 2012/026806

(56) References cited:
- EP-A1- 2 068 369
- US-A- 3 903 427
- TUCCI M ET AL: "Characterization of SiNx/a-Si:H crystalline silicon surface passivation under UV light exposure", THIN SOLID FILMS, ELSEVIER-SEQUOIA S.A. LAUSANNE, CH, vol. 515, no. 19, 16 July 2007 (2007-07-16), pages 7625-7628, XP022820289, ISSN: 0040-6090, DOI: 10.1016/J.TSF.2006.11.107 [retrieved on 2007-08-07]
- ALTERMATT P P ET AL: "A numerical model of p-n junctions bordering on surfaces", SOLAR ENERGY MATERIALS AND SOLAR CELLS, ELSEVIER SCIENCE PUBLISHERS, AMSTERDAM, NL, vol. 74, no. 1-4, 1 October 2002 (2002-10-01), pages 165-174, XP004376939, ISSN: 0927-0248, DOI: 10.1016/S0927-0248(02)00061-2

## Description

### Technical Field

The present invention relates to photovoltaic devices and, in particular, to back or rear contact device concepts using the so-called metal wrap-through technology.

### Background

Photovoltaic devices or solar cells convert optical energy, such as solar radiation, into electrical energy. These devices are essentially composed of a layered structure, having a front surface for receiving optical radiation and a back or rear surface opposite to the front surface. The layered structure typically includes a first semiconductor layer of a first conductivity type and a second semiconductor layer of a second conductivity type extending contiguous to the first layer. The first and second conductivity types being of opposite polarity such that the first and second layers are separated by a pn-junction or depletion layer, also called active layer.

The first layer, extending adjacent to the front surface, connects to at least one electrical contact at the front surface of the layered structure, also called front contact or front electrode. The second layer connects to at least one electrical contact at the back or rear surface of the layered structure, also called rear or back contact or rear or back electrode.

Photons contained in solar radiation, for example, impinging the front surface of the photovoltaic device create electron-hole pairs in the device. These charge carriers get separated as a result of a voltage difference across the pn-junction, which voltage difference is available at the front and rear contacts. By connecting an electric load between the front and rear contacts, an electric current will flow through this load.

A single solar cell produces a relative small amount of electric energy with a relative low voltage difference between the front and rear contacts. For practical use, several solar cells have to be series connected to obtain a solar module having a higher output voltage and/or several series connected cells have to be parallel connected to obtain a solar module providing a higher output current. As cells become larger and more efficient, the output current increases and in order to limit resistive losses within this wiring, the dimensions thereof across the front surface increase. In practical photovoltaic devices and modules, among others, the electrical wiring at the front surface, in the form of bus bars or the like, contributes proportionally to shadowing losses.

With the Metal Wrap-Through, MWT, technology small apertures or vias are provided in the layered structure and extending from the front surface to the rear surface. At the back or rear surface of the layered structure a back or rear contact arrangement or back or rear contact grids are provided. By metallizing the apertures, i.e. by filling the apertures with an electrically conductive plug, an electrical contact path is provided connecting a front contact, or a plurality of front contacts of the solar cells, to the back contact arrangement.

An example of an MWT solar cell is disclosed by US 3,903,427. Within an aperture and along an electrical back conductor arrangement, a single layer of electrical insulation material is placed. This, to electrically insulate the aperture or hole and an electrically conductive plug or pass-through connector received in the hole, and to electrically insulate the electric contact arrangements at the back of the solar cell.

It will be appreciated that the back contact arrangement can be designed with appropriate dimensions to reduce electrical losses in the contact wiring of the solar module without impeding the effective amount of radiation at the front surface contributing to the energy conversion.

To increase the effective amount of radiation at the front surface for conversion into electrical energy, light trapping schemes such as surface texturing are introduced. That is, the front surface for collecting solar radiation is effectively increased by a suitable surface treatment and/or provided with a suitable anti-reflective coating. Making the back surface reflective or diffuse reflective many of the photons reaching this surface will be reflected or scattered towards the front again, which provides additional opportunities to produce electron-hole pairs in the photovoltaic device, i.e. increased generation of electrical energy.

Among others, a significant loss effect known in semiconductor devices is recombination of charge carriers at the surface of a semiconductor layer. In order to prevent the surface recombination of electrons and holes, passivating layers or films are applied at the outer surfaces of a photovoltaic device. In the area of photovoltaics, a passivating surface layer reduces surface recombination by generating an electric surface field of opposite polarity at the surface of a particular semiconductor layer.

The first and second semiconductor layers as well as the pn-junction or depletion region formed there between may extend into the circumferential outer wall of the layered structure. Further, in a metal wrap-through cell, the first and second semiconductor layers as well as the pn-junction or depletion region formed there between extend into the aperture walls of the several apertures produced in the layered structure. Accordingly, passivation should not be restricted to the front and back surface of the layered structure but should be applied also at the outer circumferential wall and, in the case of a back contact metal wrap-through photovoltaic cell, within the apertures.

### Summary

It is an object to provide a photovoltaic device, in particular a back contact metal wrap-through photovoltaic and a module comprising a plurality of photovoltaic devices with improved passivation, and a method of manufacturing thereof. The scope of the present invention is determined by the terms of the claims.

In a first aspect, there is provided a photovoltaic device comprising a layered structure having a circumferential outer wall, a front surface for receiving optical radiation, a rear surface opposite to the front surface, an electrical contact arrangement, a first semiconductor layer of a first conductivity type, which first layer extending adjacent to the front surface and having at least one electrical front contact connected to the contact arrangement, and a second semiconductor layer of a second conductivity type, the second layer extending contiguous to the first layer and having at least one electrical rear contact connected to the contact arrangement. The first and second conductivity types being of opposite polarity such that the first and second layers are separated by a pn-junction, and the first and second layer extending into the outer wall. A passivating layer of a first type covering at least part of the outer wall comprised by the depletion region across the pn-junction. A passivating layer of a second type covering at least part of the outer wall comprised by the first semiconductor layer, the passivating layer of the second type being contiguous to the passivating layer of the first, and a passivating layer of a third type covering at least part of the outer wall comprised by the second semiconductor layer, the passivating layer of the third type being contiguous to the passivating layer of the first type.

In a second aspect, there is provided a photovoltaic device, comprising a layered structure having a front surface for receiving optical radiation, a rear surface opposite to the front surface, an electrical contact arrangement at the rear surface, a first semiconductor layer of a first conductivity type, which first layer extending adjacent to the front surface and having at least one electrical front contact, and a second semiconductor layer of a second conductivity type, which second layer extending contiguous to the first layer and having at least one electrical rear contact connected to the contact arrangement. The first and second conductivity types being of opposite polarity such that the first and second layers are separated by a pn-junction. The layered structure comprising at least one aperture extending from the front surface to the rear surface, the aperture being bounded by an aperture wall and having an electrical contact path connecting the at least one electrical front contact to the electrical contact arrangement at the rear surface. A passivating layer of a first type extending in the at least one aperture and covering at least part of the aperture wall comprised by a depletion region across the pn-junction. A passivating layer of a second type extending in the at least one aperture contiguous to the passivating layer of the first type and covering part of the aperture wall comprised by the first semiconductor layer, and a passivating layer of a third type extending in the at least one aperture contiguous to the passivating layer of the first type and covering part of the aperture wall comprised by the second semiconductor layer.

Both aspects may be combined resulting in a back contact metal wrap-through photovoltaic cell device comprising passivation of the circumferential outer wall according to the first aspect and aperture passivation according to the second aspect.

Each of the passivating layers can be individually selected and matched to a particular semiconductor layer exposed at the circumferential outer wall of the layered structure and/or in an aperture, for optimally reducing unwanted surface recombination at the outer wall and/or in the apertures. In particular, short-circuiting or shunting resistance loss due to leak currents between the semiconductor layers and/or reverse breakdown effects across the pn-junction or depletion area at the outer wall and/or in the apertures, which both form an exposed wall or area of the photovoltaic device, can be effectively prevented or reduced by selecting a suitable passivation material, preferably having a substantially electrically neutral effective surface charge density. Thereby improving the efficiency of the photovoltaic device.

For the purpose of the invention, passivation materials for forming a passivating layer of the first type having a suitable electrically neutral or substantially electrically neutral effective surface charge density are amorphous silicon, annealed silicon dioxide and others.

Suitable passivation materials for forming a passivating layer of the second and third type at the first or second semiconductor layer, respectively, should have an effective surface charge density of a type opposite and higher than the corresponding semiconductor layer.

For the purpose of the invention, it has been found that an effective surface charge density Q_{f} larger than 10⁻¹⁰ cm⁻² provides an effective passivation, i.e. effectively reduces the unwanted surface recombination of semiconductor layers. Passivation materials of this type are, for example, Silicon Nitride, Silicon Dioxide, Silicon Carbide, Titanium Dioxide, Aluminium Oxide, Hafnium Oxide and others.

Silicon Nitride, Silicon Dioxide, and Silicon Carbide, for example, are used to provide passivation of n-type semiconductor material, whereas Aluminium Oxide, Titanium Oxide, and Hafnium Oxide, for example, are used provide passivation of semiconductor material of the p-type, for example.

It is noted that in a back contact metal wrap-through photovoltaic device comprising passivation of the circumferential outer wall and aperture passivation as disclosed above, at least partly, different materials may be selected for the passivating layers of the first, second and third type of the circumferential outer wall and the apertures, respectively.

The passivating layer of the first type may cover part of the circumferential outer wall and/or the aperture wall beyond the depletion region across the pn-junction and both the passivating layers of the second and third type may cover or overlap at the passivating layer of the first type. For the purpose of the present invention and the attached claims, the term contiguous used in relation to the passivating layers has to be understood to include at least partially overlapping layers, provided that the passivating layer of the first type is overlapped by any or both of the passivating layers of the second and third type. That is, any or both of the passivating layers of the second and third type are on top of the passivating layer of the first type, as seen from the circumferential outer wall and/or the aperture wall.

Among others to simplify manufacturing of the photovoltaic device, it is preferred to have the passivating layer of the second type extending over the edge of the outer circumferential wall adjacent to the front surface and/or the edge of the at least one aperture adjacent to the front surface and covering the front surface of the photovoltaic device. This passivating layer or film at the same time may exhibit a transparent anti-reflective coating for improving the collection of solar radiation, as already discussed in the introduction.

In the case of a so-called front emitter design, in which the pn-junction is provided essentially closer to the front surface than to the back or rear surface of the photovoltaic device, it has been found that shunting resistance loss and/or reverse breakdown effects at the pn-junction at the outer circumferential wall and/or in an aperture of the photovoltaic device, are already effectively reduced by having the passivating layer of the first type identical to the passivating layer of the second type. That is, the passivating layer or film of the second type covers at least both the area comprised by the first semiconductor layer or emitter and the pn-junction area or depletion region.

Preferably, for ease of manufacturing of the photovoltaic device, the passivating layers of the first and second type are integral, i.e. it is a single layer or film which may be applied in a single process step from the front surface. The passivating layer of the third type may, at least partly, cover such an integral passivating layer.

In the case of a so-called back or rear emitter design, in which the pn-junction is provided essentially closer to the back or rear surface than to the front surface of the photovoltaic device, it has been found that shunting resistance loss and/or reverse breakdown effects at the pn-junction in an aperture and/or at the outer circumferential wall of the photovoltaic device, are already effectively reduced by having the passivating layer of the first type identical to the passivating layer of the third type. That is, the passivating layer or film of the third type covers both the area comprised by the second semiconductor layer or emitter and the pn-junction area or depletion region.

Preferably, for ease of manufacturing of the photovoltaic device, the passivating layers of the first and third type are integral, i.e. it is a single layer or film which may be applied in a single process step from the back surface. The passivating layer of the second type may cover such an integral passivating layer.

The electrical wiring or electric contact tracks at the front surface and the electrical contact arrangement at the rear surface may initially be applied before the application of the respective passivating layers. From a manufacturing process point of view, however, it is preferred to apply the passivating layer on either surface first.

In the back contact metal wrap-through photovoltaic device, in an embodiment thereof, the passivating layers in the at least one aperture cover the aperture wall such to form an electrical insulating jacket that provides an electrical insulation between the layered structure, i.e. the aperture wall, and an electrically conducting electrode or an electrically conducting plug arranged in the at least one aperture.

Besides the passivating layers disclosed above, a further covering layer or a stack of layers may be provided on top of a passivating layer, to improve the efficiency of the photovoltaic device.

An example of such a further covering layer in a back contact metal wrap-through photovoltaic device is an insulating layer extending in an aperture between the passivating layers and the electrically conducting electrode from the front to the rear surface of the device.

Other examples of further covering layers are are Titanium Nitride, Silicon Nitride, and the like.

The layered structure forming the photovoltaic device according to the invention can be of any type known in practice and, in particular, of the silicon bulk type or of the thin-film type.

Silicon bulk type photovoltaic devices generally comprise a crystalline silicon wafer or bulk semiconductor material, such as monocrystalline silicon or poly- or multicrystalline silicon of an n-conductivity type or a p-conductivity type, wherein the first and second semiconductor layers are formed by suitably doting of adjacent regions or volumes of the bulk. Photovoltaic devices of this type are generally plate shaped.

A thin-film solar cell or photovoltaic device is produced by depositing the semiconductor layers as thin layers (thin film) on a substrate. The thickness range of such a layer is wide and varies from a few nanometers to tens of micrometers. Cadmium Telluride, CdTe, Copper Indium Gallium Selenide, CIGS, and Amorphous Silicon, a-Si, are three thin-film technologies often used for outdoor photovoltaic solar power production. Thin-film devices may have varying shapes.

Photovoltaic devices of the silicon bulk type and the thin-film silicon type are well known to the skilled person. For the purpose of the present invention no further elucidation is required.

In a third aspect, there is provided a method of manufacturing a photovoltaic device comprising a layered structure having a circumferential outer wall, a front surface for receiving optical radiation and a rear surface opposite to the front surface. The method comprising providing a first semiconductor layer of a first conductivity type, the first layer extending adjacent to the front surface and into the outer wall, and comprising at least one electrical front contact. Providing a second semiconductor layer of a second conductivity type, the second layer extending contiguous to the first layer and into the outer wall, and comprising at least one electrical rear contact, wherein the first and second conductivity types being of opposite polarity such that the first and second layers are separated by a pn-junction. Providing an electrical contact arrangement. Electrically connecting the at least one front and rear contact to the electrical contact arrangement. The method further comprises the steps of covering at least part of the circumferential outer wall substantially comprised by a depletion region across the pn-junction by a passivating layer of a first type; covering at least part of the circumferential outer wall comprised by the first semiconductor layer by a passivating layer of a second type contiguous to the passivating layer of the first type, and covering at least part of the circumferential outer wall comprised by the second semiconductor layer by a passivating layer of a third type contiguous to the passivating layer of the first type.

In a fourth aspect, there is provided a method of manufacturing a photovoltaic device comprising a layered structure having a front surface for receiving optical radiation and a rear surface opposite to the front surface. The method comprising providing a first semiconductor layer of a first conductivity type, the first layer extending adjacent to the front surface and comprising at least one electrical front contact. Providing a second semiconductor layer of a second conductivity type, the second layer extending contiguous to the first layer and comprising at least one electrical rear contact, wherein the first and second conductivity types being of opposite polarity such that the first and second layers are separated by a pn-junction. Providing at least one aperture extending from the front surface to the rear surface, the aperture being bounded by an aperture wall. Providing an electrical contact arrangement at the rear surface. Electrically connecting the at least one rear contact to the electrical contact arrangement, and providing an electrical contact path electrically connecting the at least one electrical front contact through the at least one aperture to the electrical contact arrangement. The method further comprises the steps of covering at least part of the aperture wall substantially comprised by a depletion region across the pn-junction by a passivating layer of a first type; covering at least part of the aperture wall comprised by the first semiconductor layer by a passivating layer of a second type contiguous to the passivating layer of the first type, and covering at least part of the aperture wall comprised by the second semiconductor layer by a passivating layer of a third type contiguous to the passivating layer of the first type.

Both the method according to the third and fourth aspect may be combined resulting in a method for manufacturing a back contact metal wrap-through photovoltaic cell device comprising passivation of the circumferential outer wall according to the third aspect and aperture passivation according to the fourth aspect.

Surface passivation is generally applied using a Plasma Enhanced Chemical Vapour Deposition, PECVD, process, preferably followed by a post-deposition annealing process. However, for the purpose of the present invention other known deposition processes may be used, for example Atomic Layer Deposition, ALD, or a so-called wet process, wherein the passivating material to be deposited is contained in a liquid which is applied at a surface to be passified. Passivating layers or films may also be applied using a spraying method, for example.

The order in which the passivating layers of the first, second and third type are applied may vary. In an embodiment, the passivating layer of the first type, substantially covering the depletion region across the pn-junction, is applied from either one of the front surface and the rear surface, followed by a selective etching step, for example, to remove the passivating layer of the first type from the front or rear surface and from part of the circumferential outer wall and/or the aperture wall substantially comprised by the first semiconductor layer and/or the second semiconductor layer. Next the passivating layer of the second type may be applied from the front surface, such to be contiguous to the passivating layer of the first type or the passivating layer of the third type may be applied from the rear surface, such to be contiguous to the passivating layer of the first type. It is noted that the passivating layer of the second type and the third type may, at least partially, overlap the passivating layer of the first type. If required, the passivating layer of the second and/or the third type may be removed from the front and/or rear surface, for example by selective etching, if required.

The latter removal will not be applied, of course, if the passivating layer of the second type should extend over the front surface and the passivating layer of the third type should extend over the rear surface, as discussed above. In the case of a photovoltaic device of the front emitter design, it is preferred to apply the passivating layer of the second type before the passivating layer of the third type. In the case of a photovoltaic device of the back or rear emitter design, it is preferred to apply the passivating layer of the third type before the passivating layer of the second type.

In an embodiment wherein the passivating layers of the first and second type are integral, this passivating layer is applied before the passivating layer of the third type is applied. In an embodiment wherein the passivating layers of the first and third type are integral, this passivating layer is applied before the passivating layer of the second type is applied. The passivating layers may be formed contiguous with a partial overlap.

In another embodiment, the passivating layers of the second and third type may be formed first, for example from the front and rear surface, respectively, after which at least part of the passivating layers of the second and third type substantially covering part of the circumferential outer wall and/or of the aperture wall comprised by the depletion region across the pn-junction is removed. This removal can be performed, for example, by using a selective wet etching material applied at a brush or sponge or the like which is selectively swept along the circumferential outer wall and/or the aperture wall. After this removal, the passivating layer of the first type is applied on the exposed area, to be contiguous to the passivating layers of the second and third type.

It will be appreciated that in the method according to the invention passivating materials or compounds of the first, second and third type are used as disclosed above. Suitable etching materials for removing such passivating layers of the first, second and third type are known to the skilled person and need no further elaboration.

Based on the above, those skilled in the art will appreciate that the application of the passivating layers is not limited to the specific embodiments disclosed. After having applied the passivating layers as disclosed, at least one further covering layer covering at least one of the passivating layers of the first, second and third type may be applied.

In a fifth aspect there is provided a photovoltaic module comprising a plurality of electrically connected photovoltaic devices of the types disclosed above.

Those skilled in the art will appreciate that the teachings of the invention can also be applied with multi-junction or heterojunction photovoltaic devices, comprising several stacked cells of first and second semiconductor layers and their corresponding p-n junctions. Such as a top cell, a middle cell and a bottom cell, for example. Each junction or cell is tuned to a different wavelength of light, thereby increasing efficiency of the photovoltaic device as a whole.

The invention will now be described in more detail by means of specific embodiments, with reference to the enclosed drawings, wherein equal or like parts and/or components are designated by the same reference numerals. The invention is in no manner whatsoever limited to the embodiments disclosed.

### Brief Description of the Drawings

Fig. 1 shows schematically, not to scale, partly in cross-section, a portion of a substrate or wafer of a front emitter silicon bulk type prior art photovoltaic device.
Fig. 2 shows schematically, not to scale, partly in cross-section, a portion of a substrate or wafer of a front emitter silicon bulk type prior art back contact metal wrap-through photovoltaic device.
Fig. 3 shows schematically, not to scale, partly in cross-section, the photovoltaic device of Figure 1 comprising outer wall passivation according to the invention.
Fig. 4 shows schematically, not to scale, partly in cross-section, the photovoltaic device of Figure 2 comprising aperture wall passivation according to the invention.
Fig. 5 shows schematically, not to scale, partly in cross-section, a portion of a substrate or wafer of a rear emitter silicon bulk type photovoltaic device, comprising circumferential outer wall passivation according to the invention.
Fig. 6 shows schematically, not to scale, partly in cross-section, a portion of a substrate or wafer of a front emitter silicon bulk type back contact metal wrap-through photovoltaic device, comprising aperture wall passivation according to the invention.
Fig. 7 shows schematically, not to scale, partly in cross-section, a portion of a substrate or wafer of a front emitter silicon bulk type back contact metal wrap-through photovoltaic device comprising circumferential outer wall passivation and aperture wall passivation according to an embodiment of the invention.
Fig. 8 shows schematically, not to scale, partly in cross-section, a portion of a substrate or wafer of a front emitter silicon bulk type back contact metal wrap-through photovoltaic device, comprising circumferential outer wall passivation and aperture wall passivation according to an embodiment of the invention.
Fig. 9 shows schematically, not to scale, partly in cross-section, a portion of a substrate or wafer of a rear emitter silicon bulk type back contact metal wrap-through photovoltaic device, comprising circumferential outer wall passivation and aperture wall passivation according to an embodiment of the invention.
Fig, 10 shows schematically, not to scale, partly in cross-section, the photovoltaic device of Figure 8, comprising an electrically conducting plug and insulating jacket.
Fig. 11 shows schematically, not to scale, partly in exploded view, an example of a photovoltaic module comprising a plurality of electrically connected back contact metal wrap-through photovoltaic devices according to the invention.

### Detailed Description

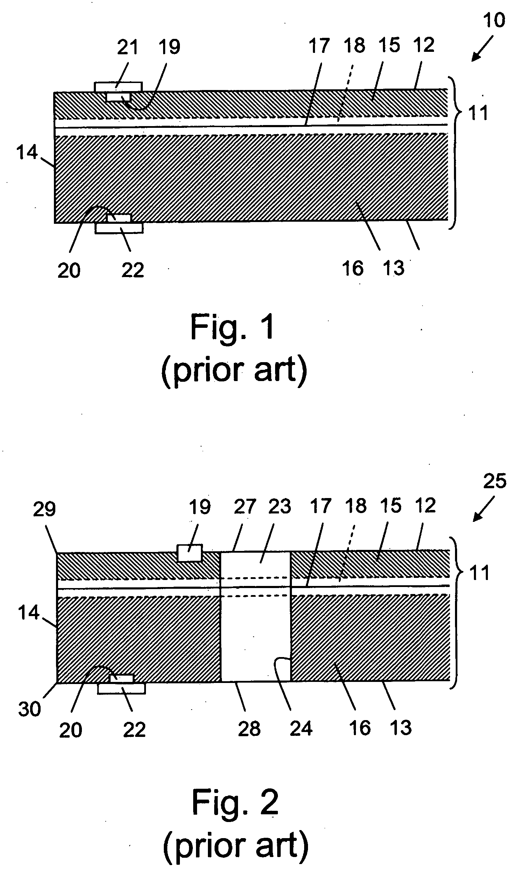

Figure 1 relates to a prior art photovoltaic device 10 of the so-called front emitter design type, comprising a plate-shaped or planar silicon substrate or wafer 11, having a front surface or receiving surface 12 for receiving optical radiation, i.e. solar radiation, a back or rear surface 13 opposite to the front surface 12 and a circumferential outer wall 14.

The substrate 11 comprises a semiconductor bulk. A first volume or region of the bulk below the front surface 12 having a doping of a first polarity or first conductivity type, such as an n-type conductivity wherein electrons form the main charge carriers, forms a first semiconductor layer 15 or emitter extending adjacent to the front surface 12. A second volume or region of the bulk between the first layer 15 and the rear surface 13 comprising a doping of a second polarity or second conductivity type, opposite to the first polarity or conductivity type, such as a p-type conductivity wherein holes form the main charge carriers, forms a second semiconductor layer 16 contiguous to the first semiconductor layer 15.

The area or region separating the first and second semiconductor layers 15, 16 is a pn-junction 17 across which a depletion region 18 instantaneously forms, indicated by broken lines. The first and second semiconductor layers 15, 16 and the pn-junction 17 or depletion region 18 extend into the circumferential outer wall 14 of the substrate or wafer 11. Or in other words, the second semiconductor layers 15, 16 and the pn-junction 17 or depletion region 18 are exposed at the circumferential outer wall of the substrate or wafer 11.

At least one electrical contact 19 electrically contacts the first layer or emitter 15 and is available from the front surface 12, also called a front surface contact. At least one electrical contact 20 electrically contacts the second layer 16 and is available from the back or rear surface 13, also called a rear surface contact. Electrical energy provided by the photovoltaic device 10 is available at the front and rear surface contacts 19, 20. To this end, at both surfaces 12, 13 of the substrate 11 a contact arrangement 21 respectively 22 is provided, in the form of an electric wiring and/or electrically conducting bus bars for electrically connecting a plurality of front and rear surface contacts 19, 20, respectively.

For producing a back contact metal wrap-through photovoltaic device 25, the layered structure of first and second semiconductor layers 15, 16 and the pn-junction 17 or depletion region 18 comprises at least one via or aperture 23 extending from the front surface 12 to the rear surface 13, as shown in Figure 2.

The at least one aperture 23 is bounded by an aperture wall 24. Although not shown for the purpose of clarity, the aperture 23 is filled with a plug of electrically conducting material providing an electrical contact path from the at least one electrical front contact 19 to an electrical contact arrangement at the rear surface 13. In practice, a plurality of apertures 23 are formed for contacting a plurality of electrical front contacts 19 to the electrical contact arrangement.

As shown in Figure 2, the first and second semiconductor layers 15, 16 and the pn-junction 17 or depletion region 18 extend into the aperture wall 24 of the at least one aperture 23. Or in other words, the second semiconductor layers 15, 16 and the pn-junction 17 or depletion region 18 are exposed at the aperture wall 24.

In practice, the first layer 15 or emitter has a thickness in the micrometer range, such as 0.5 µm, whereas the aperture 25 has a diameter of a few hundred micrometers, such as 200 µm, for example. Further, the front surface 12 may have a surface textured structure (not shown) to increase the effective amount of radiation at the front surface 12 for conversion into electrical energy. Dependent on the manufacturing process of the photovoltaic device 10, the at least one aperture 23 may be drilled, such as laser drilled, in the bulk before the first and second layers 15, 16 are produced, or the at least one aperture 23 may be drilled in the already manufactured layered structure 11.

Due to the drilling of the at least one aperture 23, and/or etching of the front and rear surfaces 12, 13 and/or texturing of the front surface12, the edge 27 of the aperture 23 at the front surface 12 and the edge 28 of the aperture 23 at the rear surface 13 may exhibit a rounded or bevelled or otherwise knurled edge structure, resulting in a widened opening of the aperture at the front and/or rear surface 12, 13, different from the sharp edges 27, 28 shown in Figure 2. Likewise, the outer edges 29, 30 of the circumferential outer wall 14 may be rounded or bevelled or knurled in practice.

For the purpose of the invention, part of the aperture edges 27, 28 flush to the front surface 12 or the rear surface 13, respectively, form part of the aperture wall 24 and part of the outer edges 29, 30 flush to the front surface 12 or the rear surface 13, respectively, form part of the circumferential outer wall 14.

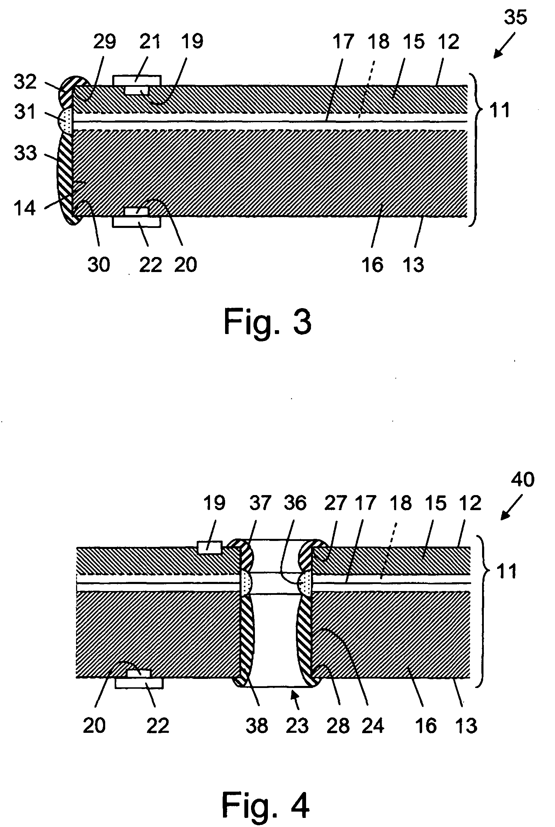

In accordance with the first aspect of the invention, as schematically shown in Figure 3, a photovoltaic device is provided, for example a photovoltaic device 35 of the front emitter type, having the layered structure as shown in Figure 1 and having passivating layers or films 31, 32 and 33 applied at the circumferential outer wall 14 of the layered structure or substrate 11.

As shown in Figure 3, a passivating layer 31 of a first type covers at least part of the area of the circumferential outer wall 14 substantially comprised by the depletion region 18 across the pn-junction 17. A passivating layer 32 of a second type covers at least part of the area of the circumferential outer wall 14 comprised by the first semiconductor layer 15. A passivating layer 33 of a third type covers at least part of the area of the circumferential outer wall 14 comprised by the second semiconductor layer 16.

The passivating layer 32 of the second type is formed contiguously to the passivating layer 31 of the first type and extends partly over the outer edge 29 of the front surface 12. The passivating layer 33 of the third type is formed contiguous to the passivating layer 31 of the first type and extends partly over the outer edge 30 of the rear surface 13. For the purpose of the invention, the term contiguous used in relation to the passivating layers 31, 32, 33 has to be understood to include adjoining passivating layers as well as at least partially overlapping passivating layers. That is one or both the passivating layers 32 and 33 may overlap the passivating layer 31 of the first type as seen from the circumferential outer wall 14. That is, any or both of the passivating layers 32 and 33 are on top of the passivating layer 31 of the first type, as seen from the circumferential outer wall 14.

Figure 4 schematically shows a front emitter photovoltaic device 40 of the back contact metal wrap-through type as shown in Figure 3, and comprising passivating layers or films 36, 37 and 38 applied at the aperture wall 24 of the aperture 23, in accordance with the second aspect of the invention.

As shown in Figure 4, a passivating layer 36 of a first type covers at least part of the area of the aperture wall 24 substantially comprised by the depletion region 18 across the pn-junction 17. A passivating layer 37 of a second type covers at least part of the area of the aperture wall 24 comprised by the first semiconductor layer 15. A passivating layer 38 of a third type covers at least part of the area of the aperture wall 24 comprised by the second semiconductor layer 16.

In a like manner as disclosed with reference to the passivation of the circumferential outer wall 14, the passivating layer 37 of the second type is formed contiguously to the passivating layer 36 of the first type and extends partly over the aperture edge 27 of the front surface 12. The passivating layer 38 of the third type is formed contiguous to the passivating layer 36 of the first type and extends partly over the aperture edge 28 of the rear surface 13. For the purpose of the invention, the term contiguous used in relation to the passivating layers 36, 37, 38 has to be understood to include adjoining passivating layers as well as at least partially overlapping passivating layers. That is one or both the passivating layers 37 and 38 may overlap the passivating layer 36 of the first type as seen from the aperture wall 24. That is, any or both of the passivating layers 37 and 38 are on top of the passivating layer 36 of the first type, as seen from the aperture wall 24.

Those skilled in the art will appreciate that passivation of the circumferential outer wall 14 may also be applied in the back contact metal wrap-through photovoltaic device 40 comprising aperture wall passivation. In such an embodiment, in practice, the passivating layers 31 and 36 are of the same first type, the passivating layers 32 and 37 are of the same second type and the passivating layers 33, 38 are of the same third type. However, its is noted that the types of passivating layers 31, 32, 33 applied at the circumferential outer wall 14 may differ from the types of passivating layers 36, 37, 38 applied at the aperture wall 24, because the passivating layers 36, 37, 38 may have to form an electrical insulation between the layered structure, i.e. the aperture wall 24, and an electrically conducting electrode or an electrically conducting plug arranged in the at least one aperture 23.

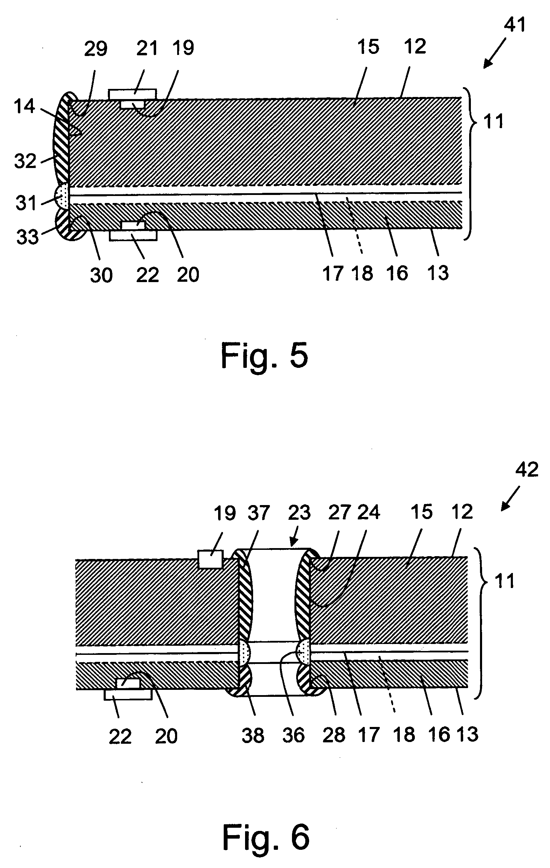

Figure 5 shows part of a photovoltaic device 41 of the rear emitter type, in which the pn-junction 17 is provided essentially closer to the rear surface 13 than to the front surface 12. The circumferential outer wall 14 of the photovoltaic device 41 is passified in accordance with the first aspect of the invention, in a manner comparable to the front emitter device 35, as discussed above and shown in Figure 3.

Figure 6 shows part of a back contact metal wrap-through photovoltaic device 42 of the rear emitter type, comprising aperture wall passivation according to the second aspect of the invention, comparable to the front emitter device 40 discussed above and shown in Figure 4. In the embodiment of Figure 6, the circumferential outer wall of the photovoltaic device 42 may be passified as shown for the photovoltaic device 41 in Figure 5.

As will be appreciated by those skilled in the art, in the photovoltaic devices illustrated in the figures 3 - 6, the front surface 12 and the rear surface 13 may be covered with further passivating layers of a suitable type (not shown).

Among others to simplify manufacturing of the photovoltaic device, it is preferred to combine passivation of the circumferential outer wall and the aperture wall with surface passivation of the front surface and/or the rear surface of a photovoltaic device.

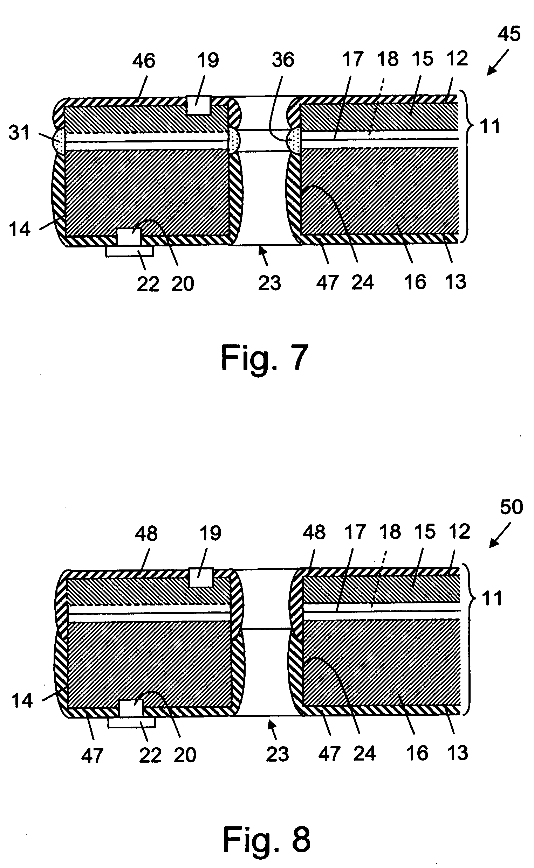

Figure 7 shows a back contact metal wrap-through photovoltaic device 45 wherein the passivating layers 32 respectively 37 of the second type extending over the outer edge 29 of the outer circumferential wall 14 or the aperture edge 27, as shown in Figures 3 - 6, cover the front surface 12 of the photovoltaic device, indicated by reference numeral 46.

Likewise, the passivating layers 33 respectively 38 of the second type extending over the outer edge 30 of the outer circumferential wall 14 or the aperture edge 28, as shown in Figures 3 - 6, may cover the rear surface 13 of the photovoltaic device, indicated by reference numeral 47.

As discussed above, the passivating layers 32 and 37 are, preferably, of the same second type, such that a single passivating layer 46 of the second type is applied. Besides its passivation properties, the passivating layer or film 46 may form a transparent anti-reflective coating for improving the collection of solar radiation by the photovoltaic device. The passivating layers 32 and 37 are, preferably, of the same second type, such that a single passivating layer 47 of the second type is applied.

In the case of a so-called front emitter design, such as shown in Figures 1 - 4 and 7, it has been found that shunting resistance loss and/or reverse breakdown effects at the pn-junction 17 at the outer circumferential wall 14 and/or in an aperture 23 of the photovoltaic device of the back contact metal wrap-through photovoltaic device, are already effectively reduced by having the passivating layer of the first type 31, 36 identical to the passivating layer of the second type 32, 37.

That is, the passivating layer or film of the second type 32, 37 covers both at least part of the area of the circumferential outer wall 14 comprised by the first semiconductor layer 15 and at least part of the area of the circumferential outer wall 14 substantially comprised by the depletion region 18 across the pn-junction 17.

Preferably, for ease of manufacturing of the photovoltaic device, the passivating layers of the first and second type are integral, i.e. it is a single layer or film which may be applied in a single process step from the front surface 12, for example. Such as illustrated in Figure 8 for a back contact metal wrap-through photovoltaic device 50, wherein a single passivating layer 48 of the second type extends over the front surface 12 of the photovoltaic device 50 and the passivating layer 47 of the third type extends over the rear surface 13 of the photovoltaic device 50. The passivating layer 47 of the third type is contiguous to the passivating layer of the second type 48, that is the passivating layers 47, 48 adjoin each other or the passivating layer 47 partly or completely overlaps the passivating layer 48 at the circumferential outer wall 14 and the aperture wall 24, as disclosed above.

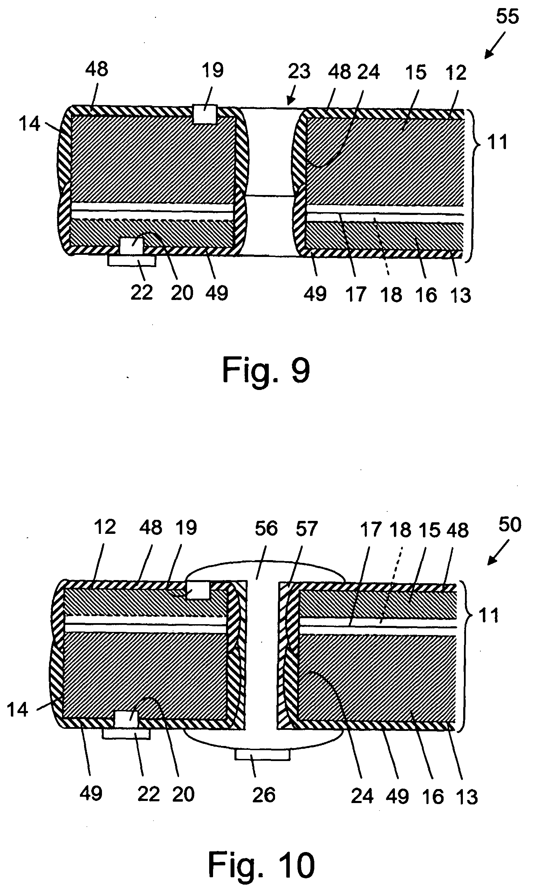

In the case of a so-called back or rear emitter design as shown in Figures 5 and 6, for example, it has been found that shunting resistance loss and/or reverse breakdown effects at the pn-junction 17 in an aperture 23 and/or at the outer circumferential wall 14 of the photovoltaic device, are already effectively reduced by having the passivating layer of the first type identical to the passivating layer of the third type. That is, a passivating layer or film of the third type covers both the rear surface 13 and the pn-junction 17, i.e. the depletion region 18 at the circumferential outer wall 14 and the aperture wall 24. Preferably, for ease of manufacturing of the photovoltaic device, the passivating layers of the first and second type are integral, i.e. it is a single layer or film 49 which may be applied in a single process step from the rear surface 13, for example, such as illustrated in Figure 9 for a back contact metal wrap-through photovoltaic device 55. The passivating layer 48 of the second type is contiguous to the passivating layer 49 of the third type. That is, the passivating layers 48, 49 adjoin each other or the passivating layer 48 partly or completely overlaps or covers the passivating layer 49 at the circumferential outer wall 14 and the aperture wall 24.

The passivating layers of the first, second and third type may have different thicknesses ranging from a few nm, like 5 nm for ALD aluminium oxide, up to a few micrometers for silicon oxide. In the case of a front emitter design, the passivating layers of the first and second type may be thinner or less thick compared to the passivating layer of the third type. In the case of a rear emitter design, the passivating layers of the first and third type may be thinner or less thick compared to the passivating layer of the second type.

In the case of a back contact metal wrap-through photovoltaic device, the passivating layers in the aperture 23 may form an electrical insulating jacket covering the aperture wall 23 to provide electrical insulation of the layered structure 11 from an electrically conducting electrode arranged in the at least one aperture 23. However, inn order to optimally select the types of passivating layers in the aperture, in an embodiment of the invention, a separate insulating jacket may be provided in the aperture 23 on top of the passivating layers, as seen from the aperture wall 24, schematically as illustrated in Figure 10.

Fig. 10 shows the back contact metal wrap-through photovoltaic device 50 of Figure 8, wherein an electrically conducting plug 56 connects the front contact 19 to a contact arrangement 26 at the rear surface 13. In the aperture 23, an electrically insulating jacket 57 surrounds the plug 56.

Those skilled in the art will appreciate that further layers, including further passivating layers, may be applied at a passivating layer of the first, second or third type, to improve the efficiency of a photovoltaic device. For the purpose of the present invention, such further layers are not further elucidated.

Instead of a silicon bulk wafer, the teachings of the invention may be likewise applied to a photovoltaic device wherein the layered structure comprises a thin-film body, and wherein the first and second semiconductor layers are applied on the thin-film body.

As discussed in the summary part, the several passivating layers 31, 32, 33; 36, 37, 38; 46, 47, 48, 49 illustrated in the drawings may be applied by any known surface passivation technique, such as a Plasma Enhanced Chemical Vapour Deposition, PECVD, process, preferably followed by a post-deposition annealing process, etching techniques, by Atomic Layer Deposition, ALD, or by a so-called wet process, wherein the passivating material to be deposited is contained in a liquid which is applied at a surface to be passified. Passivating layers or films may also be applied using a spraying method, for example.

The order in which the passivating layers of the first, second and third type are applied may vary. With reference to Figures 3, 4 and 5, 6, for example, in an embodiment, one or both the passivating layers 31; 36 of the first type, substantially covering the depletion region 18 across the pn-junction 17, are first applied from either one of the front surface 12 or the rear surface 13, followed by a selective etching step, for example, to remove the amount of passivating layer 31; 36 of the first type from the front 12 or rear surface 13 and from part of the circumferential outer wall 14 and/or the aperture wall 24 substantially comprised by the first semiconductor layer 15 and/or the second semiconductor layer 16.

It will be appreciated that in the case of a front emitter design as shown in Figures 3 and 4, the passivating layer 31; 36 of the first type is preferably applied from the front surface 12. In the case of a rear emitter design, such as shown in Figures 5 and 6, the passivating layer of the first type is preferably applied from the rear surface 13.

Next, the passivating layer 32; 37 of the second type may be applied from the front surface 12, such to be contiguous to the passivating layer 31; 36 of the first type. The passivating layer 33; 38 of the third type may be applied from the rear surface 13, such to be contiguous to the passivating layer 31; 36 of the first type. It is noted that the passivating layer 32; 37 of the second type and the passivating layer 33; 38 of the third type may, at least partially, overlap the passivating layer 31; 36 of the first type. If required, the passivating layer of the second 32; 37 and/or the third type 33; 38 may be removed from the front 12 and/or rear surface 13, for example by selective etching, if required. For example to apply surface passivation at the front surface 12 and/or the rear surface 13 using different types of passivating layers compared to the passivating layers 31, 32, 33 and 36, 37, 38.

The latter removal will not be applied, of course, if the passivating layer 32; 37 of the second type should extend over the front surface 12 and the passivating layer 33; 38 of the third type should extend over the rear surface 13, as shown in the embodiment of Figure 7, passivating layers 46 and 47, respectively.

In the case of a photovoltaic device of the front emitter design, it is preferred to apply the passivating layer 32; 37 of the second type before the passivating layer 33; 38 of the third type, such to ensure that the passivating layer 33; 38 of the third type is always on top of the passivating layer 32; 37 of the second type, if same overlap. In the case of a photovoltaic device of the back or rear emitter design, it is preferred to apply the passivating layer 33; 38 of the third type before the passivating layer 32; 37 of the second type, such to ensure that the passivating layer 32; 37 of the second type is always on top of the passivating layer 33; 38 of the third type, if same overlap.

In an embodiment of a photovoltaic device of the front emitter design, wherein the passivating layers of the first and second type are integral, such as the passivating layer 48 shown in Figure 8, this passivating layer 48 is applied from the front surface 12 before the passivating layer 49 of the third type is applied from the rear surface 13.

In an embodiment of a photovoltaic device of the rear emitter design, wherein the passivating layers of the first and third type are integral, such as the passivating layer 49 shown in Figure 9, this passivating layer 49 is applied from the rear surface 13 before the passivating layer 48 of the second type is applied from the front surface 12.

The passivating layers 48, 49 may be formed contiguous with a partial overlap. Etching may be required between the successive application steps, to remove passivating material from unwanted areas of the circumferential outer wall 14 and/or the aperture wall 24, whenever required.

In another embodiment, the passivating layers 32; 37 of the second and third 33; 38 type may be formed first, for example from the front 12 and rear surface 13, respectively, after which at least part of the passivating layers 32; 37 of the second and third 33; 38 type substantially covering part of the circumferential outer wall 14 and/or of the aperture wall 24 comprised by the depletion region 18 across the pn-junction 17 is removed. This removal can be performed, for example, by using a selective wet etching material applied at a brush or sponge or the like which is selectively swept along the passivating layer(s) covering the circumferential outer wall 14 and/or the aperture wall 24 at the position at which the passivating layer 31; 36 of the first type is to be applied. After this removal, the passivating layer 31; 36 of the first type is applied on the thus exposed area, to be contiguous to the passivating layers 32; 37 of the second and third 33; 38 type.

Suitable etching materials for removing passivating layers of the first, second and third type are known to the skilled person and need no further elaboration. Those skilled in the art will appreciate that further steps may be required, such as cleaning steps, for example.

Each of the passivating layers can be individually selected and matched to a particular semiconductor layer exposed at the circumferential outer wall of the layered structure and/or in an aperture, for optimally reducing unwanted surface recombination at the outer wall and/or in the apertures. In particular, short-circuiting or shunting resistance loss due to leak currents between the semiconductor layers and/or reverse breakdown effects across the pn-junction or depletion area at the outer wall 14 and/or in the aperture wall 24, which both generally form an exposed wall or area of the photovoltaic device, can be effectively prevented or reduced by selecting a suitable passivation material, preferably having a substantially electrically neutral effective surface charge density.

For the purpose of the invention, passivation materials for forming a passivating layer of the first type having a suitable electrically neutral or substantially electrically neutral effective surface charge density are amorphous silicon, annealed silicon dioxide and others.

Suitable passivation materials for forming a passivating layer of the second and third type at the first or second semiconductor layer, respectively, should have an effective surface charge density of a type opposite and higher than the corresponding semiconductor layer, as required by the terms of the present invention.

For the purpose of the invention, it has been found that an effective surface charge density Q_{f} larger than 10⁻¹⁰ cm⁻² provides an effective passivation, i.e. effectively reduces the unwanted surface recombination of semiconductor layers. Passivation materials of this type are, for example, Silicon Nitride, Silicon Dioxide, Silicon Carbide, Titanium Dioxide, Aluminium Oxide, Hafnium Oxide and others.

Silicon Nitride, Silicon Dioxide, and Silicon Carbide, for example, are used to provide passivation of n-type semiconductor material, whereas Aluminium Oxide, Titanium Oxide, and Hafnium Oxide, for example, are used provide passivation of semiconductor material of the p-type, for example.

It is noted that in a back contact metal wrap-through photovoltaic device comprising passivation of the circumferential outer wall and aperture passivation as disclosed above, at least partly, different materials may be selected for the passivating layers of the first, second and third type of the circumferential outer wall and the apertures, respectively.

After having the passivation layers for passivation of the circumferential outer wall 14 and the aperture wall 24 have been applied, as discussed above, electrical wiring and the like may be applied at the front and rear surfaces 12, 13 and further layers may be applied on top these passivating layers, for example, using any known deposition process. Such steps are well-known to the skilled person.

The invention is likewise applicable with a photovoltaic device comprising a plurality of stacked first 15 and second semiconductor layers 16 and pn-junctions 17, also called multi-junction or heterojunction photovoltaic devices, such that for each pn-junction 17 and semiconductor layer 15, 16 optimal passivating layer 31, 32, 33 or 36, 37, 38 or combinations of passivating layers is applied, following the teachings above.

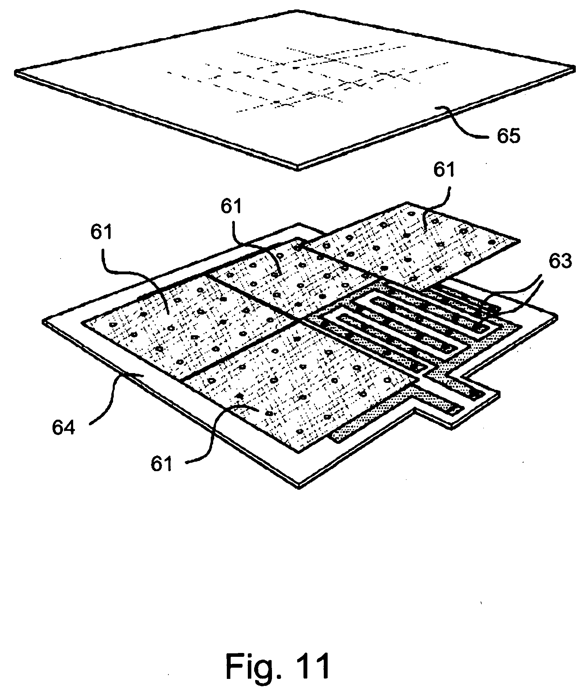

Fig. 11 shows an embodiment of a photovoltaic module 60 comprising a plurality of electrically connected back contact metal wrap-through photovoltaic devices or solar cells 61 according to the invention. A contact arrangement 62 on a support 64 is defined to match the electrical pattern of the back contacts of the photovoltaic devices 61. Solder paste 63 is applied to each of the contact positions, indicated by small circles, for electrically connecting the back contacts of each photovoltaic device 61 and the contact arrangement 62. The photovoltaic devices 61 are positioned onto the contact arrangement 62 such that the contact positions match. By heating the solder paste 63, the back contacts are electrically connected to the contact arrangement 62. A transparent plate 65, such as a glass plate, covers and protects the photovoltaic devices 61.

The invention may be practiced otherwise than as specifically described herein, and the abovementioned embodiments and examples are merely intended as an illustration to the skilled reader. The scope of the invention is only limited by the appended claims.

## Claims

1. A photovoltaic device (35; 41; 45), comprising:
- a layered structure having a circumferential outer wall (14), a front surface (12) for receiving optical radiation and a rear surface (13) opposite to said front surface (12);
- an electrical contact arrangement (21, 22);
- a first semiconductor layer of a first conductivity type (15), said first layer (15) extending adjacent to said front surface (12) and having at least one electrical front contact (19) connected to said contact arrangement (21);
- a second semiconductor layer of a second conductivity type (16), said second layer (16) extending contiguous to said first layer (15) and having at least one electrical rear contact (20) connected to said contact arrangement (22);
- said first and second conductivity types being of opposite polarity such that said first and second layers (15, 16) are separated by a pn-junction (17), and
- said first and second layer (15, 16) extending into said outer wall (14),
**characterized by**
- a passivating layer of a first type (31) covering part of said outer wall (14) comprised by a depletion region across said pn-junction (17);
- a passivating layer of a second type (32) covering at least part of said outer wall (14) comprised by said first semiconductor layer (15), said passivating layer of said second type (32) being contiguous to said passivating layer of said first type (31), and
- a passivating layer of a third type (33) covering at least part of said outer wall (14) comprised by said second semiconductor layer (16), said passivating layer of said third type (33) being contiguous to said passivating layer of said first type (31),
wherein said passivating layer of said second type (32; 37) has an effective surface charge density of a type opposite and higher than said first layer (15) and/or wherein said passivating layer of said third type (33; 38) has an effective surface charge density of a type opposite and higher than said second layer (16).

2. A photovoltaic device (40; 42; 45), comprising:
- a layered structure having a front surface (12) for receiving optical radiation and a rear surface (13) opposite to said front surface (12);
- an electrical contact arrangement (22) at said rear surface (13);
- a first semiconductor layer of a first conductivity type (15), said first layer (15) extending adjacent to said front surface (12) and having at least one electrical front contact (19);
- a second semiconductor layer of a second conductivity type (16), said second layer (16) extending contiguous to said first layer (15) and having at least one electrical rear contact (20) connected to said contact arrangement (22);
- said first and second conductivity types being of opposite polarity such that said first and second layers (15, 16) are separated by a pn-junction (17), and
- said layered structure comprising at least one aperture (23) extending from said front surface (12) to said rear surface (13), said aperture (23) being bounded by an aperture wall (24) and having an electrical contact path connecting said at least one electrical front contact (19) to said electrical contact arrangement at said rear surface (13),
**characterized by**
- a passivating layer of a first type (36) extending in said at least one aperture (23) and covering part of said aperture wall (24) comprised by a depletion region across said pn-junction (17);
- a passivating layer of a second type (37) extending in said at least one aperture (23) contiguous to said passivating layer of said first type (36) and covering at least part of said aperture wall (24) comprised by said first semiconductor layer (15), and
- a passivating layer of a third type (38) extending in said at least one aperture (23) contiguous to said passivating layer of said first type (36) and covering at least part of said aperture wall (24) comprised by said second semiconductor layer (16),
wherein said passivating layer of said second type (32; 37) has an effective surface charge density of a type opposite and higher than said first layer (15) and/or wherein said passivating layer of said third type (33; 38) has an effective surface charge density of a type opposite and higher than said second layer (16).

3. The photovoltaic device according to claim 2, wherein said layered structure comprises a circumferential outer wall (14) and said first and second layer (15, 16) extend into said outer wall (14), wherein part of said outer wall (14) comprised by said depletion region across said pn-junction (17) is covered by a passivating layer of said first type (36), said passivating layer of said first type (36) optionally may cover part of said outer wall (14) beyond said depletion region across said pn-junction (17), at least part of said outer wall (14) comprised by said first layer (15) is covered by a passivating layer of said second type (37) contiguous to said passivating layer of said first type (36), and at least part of said outer wall (14) comprised by said second layer (16) is covered by a passivating layer of said third type (38) contiguous to said passivating layer of said first type (36).

4. The photovoltaic device according to any of the previous claims, wherein said passivating layer of said second type (32; 37) extends over said front surface (12) and optionally said passivating layer of said second type (32; 37) is identical to said passivating layer of said first type (31; 36) and/or wherein said passivating layer of said third type (33; 38) extends over said back surface (13), or wherein said passivating layer of said third type (33; 38) extends over said back surface (13) and is identical to said passivating layer of said first type (31; 36), or wherein said passivating layer of said third type (33; 38) extends over said back surface (13) and is identical to said passivating layer of said first type (31; 36) and said passivating layer of said second type (32; 37) extends over said front surface (12).

5. The photovoltaic device according to claim 4, wherein said identical passivating layers of said first (31; 36) and second type (32; 37) are integral, or wherein said identical passivating layers of said first (31; 36) and third type (33; 38) are integral.

6. The photovoltaic device according to any of the previous claims, wherein said first semiconductor layer (15) is of an n-type conductivity and said passivating layer of said second type (32; 37) comprises one of Silicon nitride, Silicon dioxide, Silicon Carbide, and wherein said second semiconductor layer (16) is of a p-type conductivity and said passivating layer of said third type (33; 38) comprises one of aluminium oxide, titanium dioxide, hafnium oxide.

7. The photovoltaic device according to any of the claims 1, 2, 3, 4, or 5, wherein said first semiconductor layer (15) is of a p-type conductivity and said passivating layer (32; 37) of said second type comprises one of aluminium oxide, titanium dioxide, hafnium oxide, and wherein said second semiconductor layer (16) is of an n-type conductivity and said passivating layer of said third type (33; 38) comprises one of Silicon nitride, Silicon dioxide, Silicon Carbide.

8. The photovoltaic device according to any of the previous claims as far as dependent on claim 2, wherein said passivating layers (36, 37, 38) form an electrical insulating jacket covering said aperture wall (24) of said at least one aperture (23) providing an electrical insulation of said layered structure from an electrically conducting electrode (56) arranged in said at least one aperture (23).

9. A method of manufacturing a photovoltaic device (35; 41; 45) comprising a layered structure having a circumferential outer wall (14), a front surface (12) for receiving optical radiation and a rear surface (13) opposite to said front surface (12), said method comprising:
- providing a first semiconductor layer of a first conductivity type (15), said first layer (15) extending adjacent to said front surface (12) and into said outer wall (14), and comprising at least one electrical front contact (19);
- providing a second semiconductor layer of a second conductivity type (16), said second layer (16) extending contiguous to said first layer (15) and into said outer wall (14), and comprising at least one electrical rear contact (20);
- said first and second conductivity types being of opposite polarity such that said first and second layers (15, 16) are separated by a pn-junction (17);
- providing an electrical contact arrangement (21, 22), and
- electrically connecting said at least one front (19) and rear contact (20) to said electrical contact arrangement (21, 22),
**characterized by** the steps of:
- covering part of said circumferential outer wall (14) comprised by a depletion region across said pn-junction (17) by a passivating layer of a first type (31);
- covering at least part of said circumferential outer wall (14) comprised by said first semiconductor layer (15) by a passivating layer of a second type (32) contiguous to said passivating layer of said first type (31), and
- covering at least part of said circumferential outer wall (14) comprised by said second semiconductor layer (16) by a passivating layer of a third type (33) contiguous to said passivating layer of said first type (31),
wherein said passivating layer of said second type (32; 37) has an effective surface charge density of a type opposite and higher than said first layer (15) and/or wherein said passivating layer of said third type (33; 38) has an effective surface charge density of a type opposite and higher than said second layer (16).

10. A method of manufacturing a photovoltaic device (40; 42; 45) comprising a layered structure having a front surface (12) for receiving optical radiation and a rear surface (13) opposite to said front surface (12), said method comprising:
- providing a first semiconductor layer of a first conductivity type (15), said first layer (15) extending adjacent to said front surface (12) and comprising at least one electrical front contact (19);
- providing a second semiconductor layer of a second conductivity type (16), said second layer (16) extending contiguous to said first layer (15) and comprising at least one electrical rear contact (20);
- said first and second conductivity types being of opposite polarity such that said first and second layers (15, 16) are separated by a pn-junction (17),
- providing at least one aperture (23) extending from said front surface (12) to said rear surface (13), said aperture (23) being bounded by an aperture wall (24);
- providing an electrical contact arrangement (22, 26) at said rear surface (13);
- electrically connecting said at least one rear contact (20) to said electrical contact arrangement (22), and
- providing an electrical contact path (56) electrically connecting said at least one electrical front contact (19) through said at least one aperture (23) to said electrical contact arrangement (26),
**characterized by** the steps of:
- covering part of said aperture wall (24) comprised by a depletion region across said pn-junction (17) by a passivating layer of a first type (36);
- covering at least part of said aperture wall (24) comprised by said first semiconductor layer (15) by a passivating layer of a second type (37) contiguous to said passivating layer of said first type (36), and
- covering at least part of said aperture wall (24) comprised by said second semiconductor layer (16) by a passivating layer of a third type (38) contiguous to said passivating layer of said first type (37),
wherein said passivating layer of said second type (32; 37) has an effective surface charge density of a type opposite and higher than said first layer (15) and/or wherein said passivating layer of said third type (33; 38) has an effective surface charge density of a type opposite and higher than said second layer (16).

11. The method according to claim 10, wherein said layered structure comprises a circumferential outer wall (14) and said first and second layer (15, 16) extend into said outer wall (14), said method further comprising the steps of:
- covering part of said outer wall (14) comprised by said depletion region across said pn-junction (17) by a passivating layer of said first type (36), said passivating layer of said first type (36) optionally may cover part of said outer wall (14) beyond said depletion region across said pn-junction (17);
- covering at least part of said outer wall (14) comprised by said first layer (15) by a passivating layer of said second type (37) contiguous to said passivating layer of said first type (36), and
- covering at least part of said outer wall (14) comprised by said second layer (16) by a passivating layer of said third type (38) contiguous to said passivating layer of said first type (36).

12. The method according to claim 9, 10, or 11, wherein said passivating layer of said first type (31; 36) is applied from either one of said front surface (12) and said rear surface (13), followed by removal of said passivating layer of said first type (31; 36) from either one of said front (12) and rear surface (13) and from part of said layered structure comprised by said first semiconductor layer (15) and said second semiconductor layer (16), further applying said passivating layer of said second type (32; 37) from said front surface (12), such to be contiguous to said passivating layer of said first type (31; 36) and applying said passivating layer of said third type (33; 38) from said rear surface (13), such to be contiguous to said passivating layer of said first type (31; 36).

13. The method according to claim 12, wherein either one of said passivating layer of the second (32; 37) and/or the third type (33; 38) is removed from either one of said front (12) and rear surface (13).

14. A photovoltaic module comprising a plurality of electrically connected photovoltaic devices according to any of the claims 1-8.

## Patentansprüche

1. Photovoltaische Vorrichtung (35; 41; 45), aufweisend:
- eine Schichtstruktur mit einer äußeren Umfangswand (14), einer Vorderfläche (12) zum Empfang optischer Strahlung und einer Rückfläche (13), der Vorderfläche (12) gegenüberliegend;
- eine elektrische Kontaktanordnung (21, 22);
- eine erste Halbleiterschicht eines ersten Leitfähigkeitstyps (15), welche erste Schicht (15) sich benachbart der genannten Vorderfläche (12) erstreckt und zumindest einen elektrischen Vorderkontakt (19) aufweist, welcher an die genannte Kontaktanordnung (21) angeschlossen ist;
- eine zweite Halbleiterschicht eines zweiten Leitfähigkeitstyps (16), wobei sich die zweite Schicht (16) benachbart der ersten Schicht (15) erstreckt und zumindest einen elektrischen rückwärtigen Kontakt (20) aufweist, welcher mit der genannten Kontaktanordnung (22) verbunden ist;
- wobei die genannten ersten und zweiten Leitfähigkeitstypen entgegengesetzte Polarität haben derart, dass die genannten ersten und zweiten Schichten (15, 16) durch einen pn-Übergang (17) getrennt sind, und
- wobei die genannte erste und die zweite Schicht (15, 16) sich in die äußere Wand (14) erstrecken,
**gekennzeichnet durch**
- eine passivierende Schicht eines ersten Typs (31), welche einen Teil der genannten äußeren Wand (14) abdeckt und gebildet ist aus einem Verarmungsbereich über den genannten pn-Übergang (17);
- eine passivierende Schicht eines zweiten Typs (32), welche zumindest einen Teil der genannten äußeren Wand (14) abdeckt, welche **durch** die genannte erste Halbleiterschicht (15) gebildet ist, wobei die genannte passivierende Schicht des genannten zweiten Typs (32) benachbart der genannten passivierenden Schicht des genannten ersten Typs (31) angeordnet ist, und
- eine passivierende Schicht eines dritten Typs (33), welche zumindest einen Teil der genannten äußeren Wand (14) abdeckt, welche **durch** die genannte zweite Halbleiterschicht (16) gebildet ist, die genannte passivierende Schicht des genannten dritten Typs (33) benachbart der genannten passivierenden Schicht des genannten ersten Typs (31) angeordnet ist, wobei die genannte passivierende Schicht des genannten zweiten Typs (32; 37) eine effektive Oberflächenladungsdichte entgegensetzt und höher als die genannte erste Schicht (15) hat und/oder wobei die genannte passivierende Schicht des genannten dritten Typs (33; 38) eine effektive Oberflächenladungsdichte entgegengesetzt und höher als die genannte zweite Schicht (16) hat.

2. Photovoltaische Vorrichtung (40; 42; 45), aufweisend:
- eine Schichtstruktur mit einer Vorderfläche (12) zum Empfang optischer Strahlung und eine Rückfläche (13), der Vorderfläche (12) gegenüberliegend; ..
- eine elektrische Kontaktanordnung (22) an der genannten Rückfläche (13);
- eine erste Halbleiterschicht eines ersten Leitfähigkeitstyps (15), wobei sich die genannte erste Schicht (15) benachbart der genannten Vorderfläche (12) erstreckt und zumindest einen elektrischen Vorderkontakt (19) aufweist;
- eine zweite Halbleiterschicht eines zweiten Leitfähigkeitstyps (16), wobei sich die genannte zweite Schicht (16) benachbart der genannten ersten Schicht (15) erstreckt und zumindest einen elektrischen rückwärtigen Kontakt (20) aufweist, der an die genannte Kontaktanordnung (22) angeschlossen ist;
- wobei die genannten ersten und zweiten Leitfähigkeitstypen entgegengesetzte Polarität haben derart, dass die genannten ersten und zweiten Schichten (15, 16) durch einen pn-Übergang (17) getrennt sind, und
- wobei die genannte Schichtstruktur zumindest eine Öffnung (23) aufweist, die sich von der genannten Vorderfläche (12) zu der genannten Rückfläche (16) erstreckt, und wobei die genannte Öffnung (23) durch eine Öffnungswand (24) begrenzt ist und einen elektrischen Kontaktweg hat, welcher den zumindest einen elektrischen Vorderkontakt (19) mit der genannten elektrischen Kontaktanordnung an der genannten rückwärtigen Fläche (13) verbindet,
**gekennzeichnet durch**
- eine passivierende Schicht eines ersten Typs (36), die sich in der genannten zumindest einen Öffnung (23) erstreckt und einen Teil der genannten Öffnungswand (24) abdeckt, gebildet **durch** einen Verarmungsbereich über den genannten pn-Übergang (17);
- eine passivierende Schicht eines zweiten Typs (37), welche sich in der genannten zumindest einen Öffnung (23) benachbart zur genannten passivierenden Schicht des ersten Typs (36) erstreckt und zumindest einen Teil der genannten Öffnungswand (24) abdeckt, gebildet aus der genannten ersten Leitfähigkeitsschicht (15), und
- eine passivierende Schicht eines dritten Typs (38), welche sich in der genannten zumindest einen Öffnung (23) benachbart zu der genannten passivierenden Schicht des ersten Typs (36) erstreckt und zumindest einen Teil der genannten Öffnungswand (24) abdeckt, gebildet aus der genannten zweiten Halbleiterschicht (16), wobei die genannte passivierende Schicht des genannten zweiten Typs (32; 37) eine effektive Oberflächenladungsdichte eines Typs entgegengesetzt und höher gegenüber der ersten genannten Schicht (15) und/oder wobei die genannte passivierende Schicht des genannten dritten Typs (33; 38) eine effektive Oberflächenladungsdichte eines Typs entgegengesetzt und höher gegenüber der zweiten genannten Schicht (16) hat.

3. Photovoltaische Vorrichtung gemäß Anspruch 2, wobei die genannte Schichtstruktur eine äußere Umfangswand (14) aufweist und sich die genannte erste und die zweite Schicht (15, 16) in die genannte Umfangswand (14) erstrecken, wobei ein Teil der genannten äußeren Wand (14), gebildet durch den genannten Verarmungsbereich über den genannten pn-Übergang (17), durch eine passivierende Schicht des genannten ersten Typs (36) abgedeckt ist, wobei die genannte passivierende Schicht des genannten ersten Typs (36) optional einen Teil der genannten äußeren Wand (14) unter dem genannten Verarmungsbereich über den genannten pn-Übergang (17) abdecken kann, zumindest ein Teil der genannten äußeren Wand (14) aus der genannten ersten Schicht (15) durch eine passivierende Schicht des genannten zweiten Typs (37) benachbart zur passivierenden Schicht des genannten ersten Typs (36) abgedeckt ist und zumindest ein Teil der genannten äußeren Wand (14) aus der genannten zweiten Schicht (16) durch eine passivierende Schicht des genannten dritten Typs (38) benachbart zur genannten passivierenden Schicht des genannten ersten Typs (36) abgedeckt ist.

4. Photovoltaische Vorrichtung gemäß einem der vorhergehenden Ansprüche, wobei die genannte passivierende Schicht des genannten zweiten Typs (32; 37) sich über die genannte Vorderfläche (12) erstreckt und optional die genannte passivierende Schicht des genannten zweiten Typs (32; 37) identisch ist zur passivierenden Schicht des genannten ersten Typs (31; 36) und/oder wobei die genannte passivierende Schicht des genannten dritten Typs (33; 38) sich über die genannte Rückfläche (13) erstreckt, oder wobei die genannte passivierende Schicht des genannten dritten Typs (33; 38) sich über die genannte Rückfläche (13) erstreckt und identisch ist zur genannten passivierenden Schicht des genannten ersten Typs (31; 36), oder wobei die genannte passivierende Schicht des genannten dritten Typs (33; 38) sich über die genannte Rückfläche (13) erstreckt und identisch ist zur genannten passivierenden Schicht des genannten ersten Typs (31; 36) und die genannte passivierende Schicht des genannten zweiten Typs (32; 37) sich über die genannte Vorderfläche (12) erstreckt.

5. Photovoltaische Vorrichtung gemäß Anspruch 4, wobei die genannten identischen passivierenden Schichten des genannten ersten (31; 36) und zweiten Typs (32; 37) integral sind, oder wobei die genannten identischen passivierenden Schichten des genannten ersten (31; 36) und dritten Typs (33; 38) integral sind.

6. Photovoltaische Vorrichtung gemäß einem der vorhergehenden Ansprüche, wobei die genannte erste Halbleiterschicht (15) eine Leitfähigkeit vom n-Typ hat und die genannte passivierende Schicht des genannten zweiten Typs (32; 37) Siliciumnitrid oder Siliciumdioxid oder Siliciumkarbid aufweist und wobei die genannte zweite Halbleiterschicht (16) eine Leitfähigkeit vom p-Typ hat und die genannte passivierende Schicht des genannten dritten Typs (33; 38) Aluminiumoxid, Titanoxid oder Hafniumoxid aufweist.

7. Photovoltaische Vorrichtung gemäß einem der Ansprüche 1, 2, 3, 4 oder 5, wobei die genannte erste Halbleiterschicht (15) eine Leitfähigkeit vom p-Typ hat und die genannte passivierende Schicht (32; 37) des genannten zweiten Typs Aluminiumoxid oder Titanoxid oder Hafniumoxid aufweist, und wobei die genannte zweite Halbleiterschicht (16) eine Leitfähigkeit vom n-Typ hat und die genannte passivierende Schicht des genannten dritten Typs (33; 38) Siliciumnitrid oder Siliciumdioxid oder Siliciumcarbid aufweist.

8. Photovoltaische Vorrichtung gemäß einem der vorhergehenden Ansprüche, soweit abhängig von Anspruch 2, wobei die genannten passivierenden Schichten (36, 37, 38) eine elektrisch isolierende Abdeckung bilden, welche die genannte Öffnungswand (24) der genannten zumindest einen Öffnung (23) abdeckt für eine elektrische Isolation der genannten Schichtstruktur von einer elektrisch leitenden Elektrode (56), welche in der genannten zumindest einen Öffnung (23) angeordnet ist.

9. Verfahren zum Herstellen einer photovoltaischen Vorrichtung (35; 41; 45) aus einer Schichtstruktur mit einer äußeren Umfangswand (14), einer Vorderfläche (12) zum Empfang optischer Strahlung und einer Rückfläche (13) gegenüberliegend zur Vorderfläche (12), wobei das Verfahren aufweist:
- Bereitstellen einer ersten Halbleiterschicht eines ersten Leitfähigkeitstyps (15), wobei sich die genannte erste Schicht (15) benachbart zur genannten Vorderfläche (12) und in die genannte äußere Wand (14) erstreckt, und mit zumindest einem elektrischen Vorderkontakt (19);
- Bereitstellen einer zweiten Halbleiterschicht eines zweiten Leitfähigkeitstyps (16), wobei die genannte zweite Schicht (16) sich benachbart zur genannten ersten Schicht (15) und in die genannte äußere Wand (14) erstreckt, und mit zumindest einem elektrischen rückwärtigen Kontakt (20);
wobei die genannten ersten und zweiten Leitfähigkeitstypen entgegengesetzt Polarität aufweisen derart, dass die genannten ersten und zweiten Schichten (16, 16) durch einen pn-Übergang (17) getrennt sind;
- Bereitstellen einer elektrischen Kontaktanordnung (21, 22), und
- elektrisches Verbinden des genannten zumindest einen Vorder- (19) und rückwärtigen Kontaktes (20) mit der elektrischen Kontaktanordnung (21, 22), **gekennzeichnet durch** folgende Schritte:
- Abdecken eines Teils der genannten äußeren Umfangswand (14), welcher **durch** einen Verarmungsbereich über den genannten pn-Übergang (17) gebildet ist, **durch** eine passivierende Schicht eines ersten Typs (31);
- Abdecken zumindest eines Teils der genannten äußeren Wand (14), welcher gebildet ist **durch** die genannte erste Halbleiterschicht (15), **durch** eine passivierende Schicht eines zweiten Typs (32), benachbart zur genannten passivierenden Schicht des genannten ersten Typs (31), und
- Abdecken zumindest eines Teils der genannten äußeren Umfangswand (14), gebildet **durch** die genannte zweite Halbleiterschicht (16), **durch** eine passivierende Schicht eines dritten Typs (33) benachbart zur genannten passivierenden Schicht des genannten ersten Typs (31),
wobei die genannte passivierende Schicht des genannten zweiten Typs (32; 37) eine effektive Oberflächenladungsdichte hat entgegengesetzt und höher im Vergleich zu der genannten ersten Schicht (15) und/oder wobei die genannte passivierende Schicht vom genannten dritten Typ (33; 38) eine effektive Oberflächenladungsdichte von einem Typ entgegengesetzt und höher im Vergleich zu der genannten zweiten Schicht (16) hat.

10. Verfahren zum Herstellen einer photovoltaischen Vorrichtung (40; 42; 45), welche eine Schichtstruktur aufweist mit einer Vorderfläche (12) zum Empfang optischer Strahlung und einer Rückfläche (13) entgegengesetzt zur Vorderfläche (12), wobei das Verfahren aufweist:
- Bereitstellen einer ersten Halbleiterschicht eines ersten Leitfähigkeitstyps (15), wobei die genannte erste Schicht (15) sich benachbart zur genannten Vorderfläche (12) erstreckt und zumindest einen vorderen elektrischen Kontakt (19) aufweist;
- Bereitstellen einer zweiten Halbleiterschicht eines zweiten Leitfähigkeitstyps (16), wobei die genannte zweite Schicht (16) sich benachbart zur genannten ersten Schicht (15) erstreckt und zumindest einen rückwärtigen elektrischen Kontakt (20) aufweist;
- wobei die genannten ersten und zweiten Leitfähigkeitstypen entgegengesetzte Polarität haben derart, dass die genannten ersten und zweiten Schichten (15) durch einen pn-Übergang (17) getrennt sind,
- Bereitstellen zumindest einer Öffnung (23), die sich von der Vorderfläche (12) zur Rückfläche (13) erstreckt, wobei die genannte Öffnung (23) durch eine Öffnungswand (24) begrenzt ist;
- Bereitstellen einer elektrischen Kontaktanordnung (22, 26) an der Rückfläche (13);
- elektrisches Verbinden des genannten zumindest einen rückwärtigen Kontaktes (20) mit der genannten elektrischen Kontaktanordnung (22), und
- Bereitstellen eines elektrischen Kontaktweges (56), welcher den genannten zumindest einen elektrischen Vorderkontakt (19) durch die genannte zumindest eine Öffnung (23) mit der genannten elektrischen Kontaktanordnung (26) verbindet, **gekennzeichnet durch** folgende Schritte:
- Abdecken eines Teils der genannten Öffnungswand (24), gebildet **durch** einen Verarmungsbereich über den genannten pn-Übergang (17), **durch** eine passivierende Schicht eines ersten Typs (36);
- Abdecken zumindest eines Teils der genannten Öffnungswand (24), gebildet durch die genannte erste Halbleiterschicht (15), **durch** eine passivierende Schicht eines zweiten Typs (37) benachbart zur passivierenden Schicht des genannten ersten Typs (36), und
- Abdecken zumindest eines Teils der genannten Öffnungswand (24), gebildet aus der genannten zweiten Halbleiterschicht (16), **durch** eine passivierende Schicht eines dritten Typs (38) benachbart zur passivierenden Schicht des genannten ersten Typs (37),
- wobei die genannte passivierende Schicht des genannten zweiten Typs (32; 37) eine effektive Oberflächenladungsdichte aufweist vom Typ entgegengesetzt und höher im Vergleich zur genannten ersten Schicht (15), und/oder wobei die genannte passivierende Schicht des genannten dritten Typs (33; 38) eine effektive Oberflächenladungsdichte aufweist vom Typ entgegengesetzt und höher im Vergleich zur genannten zweiten Schicht (16).

11. Verfahren gemäß Anspruch 10, wobei die genannte Schichtstruktur eine äußere Umfangswand (14) aufweist und sich die genannten ersten und zweiten Schichten (15, 16) in die genannte äußere Wand (14) erstrecken und wobei das Verfahren weiterhin folgende Schritte aufweist:
- Abdecken eines Teils der genannten äußeren Wand (14), gebildet durch den genannten Verarmungsbereich über dem genannten pn-Übergang (17), durch eine passivierende Schicht eines ersten Typs (36), wobei die passivierende Schicht des genannten ersten Typs (36) optional einen Teil der genannten Außenwand (14) unterhalb des genannten Verarmungsbereichs über dem genannten pn-Übergang (17) abdecken kann;
- Abdecken zumindest eines Teils der genannten äußeren Wand (14), gebildet aus der genannten ersten Schicht (15), durch eine passivierende Schicht des genannten zweiten Typs (37) benachbart zur passivierenden Schicht des genannten ersten Typs (36), und
- Abdecken zumindest eines Teils der äußeren Wand (14), gebildet durch die genannte zweite Schicht (16) durch eine passivierende Schicht vom genannten dritten Typ (38) benachbart zur passivierenden Schicht des genannten ersten Typs (36).

12. Verfahren gemäß Anspruch 9, 10 oder 11, wobei die genannte passivierende Schicht vom genannten ersten Typ (31; 36) von entweder der genannten Vorderfläche (12) oder der genannten rückwärtigen Fläche (13) her aufgetragen wird, mit nachfolgender Entfernung der genannten passivierenden Schicht vom genannten ersten Typ (31; 36) entweder von der Vorderfläche (12) oder der rückwärtigen Fläche (13) her und vom Teil der genannten Schichtstruktur, gebildet durch die genannte erste Halbleiterschicht (15) und die genannte zweite Halbleiterschicht (16), und weiterhin Auftragen der genannten passivierenden Schicht des genannten zweiten Typs (32; 37) von der genannten Vorderfläche (12) her derart, dass sie benachbart ist zur genannten passivierenden Schicht vom ersten Typ (31; 36) und Auftragen der genannten passivierenden Schicht vom dritten Typ (3; 38) von der rückwärtigen Fläche (13) her derart, dass sie benachbart ist zur passivierenden Schicht vom genannten ersten Typ (31; 36).

13. Verfahren gemäß Anspruch 12, wobei die genannte passivierende Schicht vom zweiten Typ (32; 37) und/oder vom dritten Typ (33; 38) entweder von der Vorderfläche (12) oder von der rückwärtigen Fläche (13) entfernt wird.

14. Photovoltaische Baugruppe mit einer Mehrzahl von elektrisch verbundenen photovoltaischen Vorrichtungen gemäß einem der Ansprüche 1 bis 8.

## Revendications

1. Dispositif photovoltaïque (35 ; 41 ; 45) comprenant :
- une structure stratifiée présentant une surface externe (14) périphérique, une surface avant (12) permettant de recevoir un rayonnement optique et une surface arrière (13) opposée à ladite surface avant (12) ;
- un agencement de contact électrique (21, 22) ;
- une première couche semi-conductrice d'un premier type de conductivité (15), ladite première couche (15) s'étendant de manière à être adjacente à ladite surface avant (12) et comprenant au moins un contact électrique avant (19) connecté au dit agencement de contact (21) ;
- une seconde couche semi-conductrice d'un deuxième type de conductivité (16), ladite seconde couche (16) s'étendant de manière à être contiguë à ladite première couche (15) et comprenant au moins un contact électrique arrière (20) connecté au dit agencement de contact électrique (22) ;
- lesdits premier et deuxième types de conductivité étant de polarités opposées, de telle sorte que lesdites première et seconde couches (15, 16) sont séparées par une jonction pn (17), et
- lesdites première et seconde couches (15, 16) s'étendant dans ladite paroi externe (14),
**caractérisé par**
- une couche de passivation d'un premier type (31) qui recouvre une partie de ladite paroi externe (14) constituée d'une région d'appauvrissement à travers ladite jonction pn (17) ;
- une couche de passivation d'un deuxième type (32) qui recouvre au moins une partie de ladite paroi externe (14) constituée de ladite première couche semi-conductrice (15), ladite couche de passivation dudit deuxième type (32) étant contiguë à ladite couche de passivation dudit premier type (31), et
- une couche de passivation d'un troisième type (33) qui recouvre au moins une partie de ladite paroi externe (14) constituée de ladite seconde couche semi-conductrice (16), ladite couche de passivation dudit troisième type (33) étant contiguë à ladite couche de passivation dudit premier type (31),
dans lequel ladite couche de passivation dudit deuxième type (32 ; 37) a une densité de charge surfacique effective d'un type opposé et supérieur à ladite première couche (15) et/ou dans lequel ladite couche de passivation dudit troisième type (33 ; 38) a une densité de charge surfacique effective d'un type opposé et supérieur à ladite seconde couche (16).

2. Dispositif photovoltaïque (40 ; 42 ; 45) comprenant :
- une structure stratifiée présentant une surface avant (12) permettant de recevoir un rayonnement optique et une surface arrière (13) opposée à ladite surface avant (12),
- un agencement de contact électrique (22) au niveau de ladite surface arrière (13) ;
- une première couche semi-conductrice d'un premier type de conductivité (15), ladite première couche (15) s'étendant de manière à être adjacente à ladite surface avant (12) et comprenant au moins un contact électrique avant (19) ;
- une seconde couche semi-conductrice d'un deuxième type de conductivité (16), ladite seconde couche (16) s'étendant de manière à être contiguë à ladite première couche (15) et comprenant au moins un contact électrique arrière (20) connecté au dit agencement de contact électrique (22) ;
- lesdits premier et deuxième types de conductivité étant de polarités opposées, de telle sorte que lesdites première et seconde couches (15, 16) sont séparées par une jonction pn (17), et
- ladite structure stratifiée comprenant au moins une ouverture (23) qui s'étend entre ladite surface avant (12) et ladite surface arrière (13), ladite ouverture (23) étant limitée par une paroi d'ouverture (24) et comprenant un passage de contact électrique connectant ledit au moins un contact électrique avant (19) avec ledit agencement de contact électrique (22) au niveau de ladite surface arrière (13),
**caractérisé par**
- une couche de passivation d'un premier type (36) qui s'étend dans ladite au moins une ouverture (23) et qui recouvre une partie de ladite paroi d'ouverture (24) constituée d'une région d'appauvrissement à travers ladite jonction pn (17) ;
- une couche de passivation d'un deuxième type (37) qui s'étend dans ladite au moins une ouverture (23) de manière à être contiguë à ladite couche de passivation dudit premier type (36) et qui recouvre au moins une partie de ladite paroi d'ouverture (24) constituée de ladite première couche semi-conductrice (15), et
- une couche de passivation d'un troisième type (38) qui s'étend dans ladite au moins une ouverture (23) de manière à être contiguë à ladite couche de passivation dudit premier type (36) et qui recouvre au moins une partie de ladite paroi d'ouverture (24) constituée de ladite seconde couche semi-conductrice (16),
dans lequel ladite couche de passivation dudit deuxième type (32 ; 37) a une densité de charge surfacique effective d'un type opposé et supérieur à ladite première couche (15) et/ou dans lequel ladite couche de passivation dudit troisième type (33 ; 38) a une densité de charge surfacique effective d'un type opposé et supérieur à ladite seconde couche (16).

3. Dispositif photovoltaïque selon la revendication 2, dans lequel ladite structure stratifiée comprend une paroi externe (14) périphérique et lesdites première et seconde couches (15, 16) s'étendent dans ladite paroi externe (14), dans lequel une partie de ladite paroi externe (14) constituée de ladite région d'appauvrissement à travers ladite jonction pn (17) est recouverte d'une couche de passivation dudit premier type (36), ladite couche de passivation dudit premier type (36) peut, en option, recouvrir une partie de ladite paroi externe (14) au-delà de ladite région d'appauvrissement à travers ladite jonction pn (17), au moins une partie de ladite paroi externe (14) constituée de ladite première couche (15) est recouverte d'une couche de passivation dudit deuxième type (37) de manière à être contiguë à ladite couche de passivation dudit premier type (36), et au moins une partie de ladite paroi externe (14) constituée de ladite seconde couche (16) est recouverte d'une couche de passivation dudit troisième type (38) de manière à être contiguë à ladite couche de passivation dudit premier type (36).

4. Dispositif photovoltaïque selon l'une quelconque des revendications précédentes, dans lequel ladite couche de passivation dudit deuxième type (32 ; 37) s'étend sur ladite surface avant (12) et, en option, ladite couche de passivation dudit deuxième type (32 ; 37) est identique à ladite couche de passivation dudit premier type (31 ; 36) et/ou dans lequel ladite couche de passivation dudit troisième type (33 ; 38) s'étend sur ladite surface arrière (13), ou dans lequel ladite couche de passivation dudit troisième type (33 ; 38) s'étend sur ladite surface arrière (13) et est identique à ladite couche de passivation dudit premier type (31 ; 36), ou dans lequel ladite couche de passivation dudit troisième type (33 ; 38) s'étend sur ladite surface arrière (13) et est identique à ladite couche de passivation dudit premier type (31 ; 36) et ladite couche de passivation dudit deuxième type (32 ; 37) s'étend sur ladite surface avant (12).

5. Dispositif photovoltaïque selon la revendication 4, dans lequel lesdites couches de passivation identiques desdits premier (31 ; 36) et deuxième (32 ; 37) types sont intégrales, ou dans lequel lesdites couches de passivation identiques desdits premier (31 ; 36) et troisième (33 ; 38) types sont intégrales.

6. Dispositif photovoltaïque selon l'une quelconque des revendications précédentes, dans lequel ladite première couche semi-conductrice (15) a une conductivité de type n et ladite couche de passivation dudit deuxième type (32 ; 37) comprend l'un parmi le nitrure de silicium, le dioxyde de silicium, le carbure de silicium, et dans lequel ladite seconde couche semi-conductrice (16) a une conductivité du type p et ladite couche de passivation dudit troisième type (33 ; 38) comprend l'un parmi l'oxyde d'aluminium, le dioxyde de titane, l'oxyde d'hafnium.

7. Dispositif photovoltaïque selon l'une quelconque des revendications 1, 2, 3, 4 ou 5, dans lequel ladite première couche semi-conductrice (15) a une conductivité de type p et ladite couche de passivation (32 ; 37) dudit deuxième type comprend l'un parmi l'oxyde d'aluminium, le dioxyde de titane, l'oxyde d'hafnium, et dans lequel ladite seconde couche semi-conductrice (16) a une conductivité du type n et ladite couche de passivation dudit troisième type (33 ; 38) comprend l'un parmi le nitrure de silicium, le dioxyde de silicium, le carbure de silicium.

8. Dispositif photovoltaïque selon l'une quelconque des revendications précédentes dans la mesure où elles sont dépendantes de la revendication 2, dans lequel lesdites couches de passivation (36, 37, 38) forment une enveloppe isolante électrique qui recouvre ladite paroi d'ouverture (24) de ladite au moins une ouverture (23) en fournissant une isolation électrique de ladite structure stratifiée par rapport à une électrode conductrice électriquement (56) agencée dans ladite au moins une ouverture (23).

9. Procédé de fabrication d'un dispositif photovoltaïque (35 ; 41 ; 45) comprenant une structure stratifiée présentant une paroi externe (14) périphérique, une surface avant (12) permettant de recevoir un rayonnement optique et une surface arrière (13) opposée à ladite surface avant (12), ledit procédé comprenant :
- la fourniture d'une première couche semi-conductrice d'un premier type de conductivité (15), ladite première couche (15) s'étendant de manière à être adjacente à ladite surface avant (12) et dans ladite paroi externe (14), et comprenant au moins un contact électrique avant (19) ;
- la fourniture d'une seconde couche semi-conductrice d'un deuxième type de conductivité (16), ladite seconde couche (16) s'étendant de manière à être contiguë à ladite première couche (15) et dans ladite paroi externe (14), et comprenant au moins un contact électrique arrière (20) ;
- lesdits premier et deuxième types de conductivité étant de polarités opposées, de telle sorte que lesdites première et seconde couches (15, 16) sont séparées par une jonction pn (17),
- la fourniture d'un agencement de contact électrique (21, 22), et
- le raccordement électrique dudit au moins un contact avant (19) et contact arrière (20) au dit agencement de contact électrique (21, 22),
**caractérisé par** les étapes consistant à :
- recouvrir une partie de ladite paroi externe (14) périphérique constituée d'une région d'appauvrissement à travers ladite jonction pn (17) d'une couche de passivation d'un premier type (31) ;
- recouvrir au moins une partie de ladite paroi externe (14) périphérique constituée de ladite première couche semi-conductrice (15) d'une couche de passivation d'un deuxième type (32) de manière à être contiguë à ladite couche de passivation dudit premier type (31), et
- recouvrir au moins une partie de ladite paroi externe (14) périphérique constituée de ladite seconde couche semi-conductrice (16) d'une couche de passivation d'un troisième type (33) de manière à être contiguë à ladite couche de passivation dudit premier type (31),
dans lequel ladite couche de passivation dudit deuxième type (32 ; 37) a une densité de charge surfacique effective d'un type opposé et supérieur à ladite première couche (15) et/ou dans lequel ladite couche de passivation dudit troisième type (33 ; 38) a une densité de charge surfacique effective d'un type opposé et supérieur à ladite seconde couche (16).

10. Procédé de fabrication d'un dispositif photovoltaïque (40 ; 42 ; 45) comprenant une structure stratifiée présentant une surface avant (12) permettant de recevoir un rayonnement optique et une surface arrière (13) opposée à ladite surface avant (12), ledit procédé comprenant :
- la fourniture d'une première couche semi-conductrice d'un premier type de conductivité (15), ladite première couche (15) s'étendant de manière à être adjacente à ladite surface avant (12) et comprenant au moins un contact électrique avant (19) ;
- la fourniture d'une seconde couche semi-conductrice d'un deuxième type de conductivité (16), ladite seconde couche (16) s'étendant de manière à être contiguë à ladite première couche (15) et comprenant au moins un contact électrique arrière (20) ;
- lesdits premier et deuxième types de conductivité étant de polarités opposées, de telle sorte que lesdites première et seconde couches (15, 16) sont séparées par une jonction pn (17),
- la fourniture d'au moins une ouverture (23) qui s'étend entre ladite surface avant (12) et ladite surface arrière (13), ladite ouverture (23) étant limitée par une paroi d'ouverture (24) ;
- la fourniture d'un agencement de contact électrique (22, 26) au niveau de ladite surface arrière (13) ;
- la connexion électrique dudit au moins un contact arrière (20) avec ledit agencement de contact électrique (22) ; et
- la fourniture d'un passage de contact électrique (56) qui connecte électriquement ledit au moins un contact électrique avant (19) à travers ladite au moins une ouverture (23) avec ledit agencement de contact électrique (26),
**caractérisé par** les étapes consistant à :
- recouvrir une partie de ladite paroi d'ouverture (24) constituée d'une région d'appauvrissement à travers ladite jonction pn (17) d'une couche de passivation d'un premier type (36) ;
- recouvrir au moins une partie de ladite paroi d'ouverture (24) constituée de ladite première couche semi-conductrice (15) d'une couche de passivation d'un deuxième type (37) de manière à être contiguë à ladite couche de passivation dudit premier type (36), et
- recouvrir au moins une partie de ladite paroi d'ouverture (24) constituée de ladite seconde couche semi-conductrice (16) d'une couche de passivation d'un troisième type (38) de manière à être contiguë à ladite couche de passivation dudit premier type (37),
dans lequel ladite couche de passivation dudit deuxième type (32 ; 37) a une densité de charge surfacique effective d'un type opposé et supérieur à ladite première couche (15) et/ou dans lequel ladite couche de passivation dudit troisième type (33 ; 38) a une densité de charge surfacique effective d'un type opposé et supérieur à ladite seconde couche (16).

11. Procédé selon la revendication 10, dans laquelle ladite structure stratifiée comprend une paroi externe (14) périphérique et lesdites première et seconde couches (15, 16) s'étendent dans ladite paroi externe (14), ledit procédé comprenant en outre les étapes consistant à :
- recouvrir une partie de ladite paroi externe (14) constituée de ladite région d'appauvrissement à travers ladite jonction pn (17) d'une couche de passivation dudit premier type (36), ladite couche de passivation dudit premier type (36) peut, en option, recouvrir une partie de ladite paroi externe (14) au-delà de ladite région d'appauvrissement à travers ladite jonction pn (17) ;
- recouvrir au moins une partie de ladite paroi externe (14) constituée de ladite première couche (15) d'une couche de passivation dudit deuxième type (37) de manière à être contiguë à ladite couche de passivation dudit premier type (36), et
- recouvrir au moins une partie de ladite paroi externe (14) constituée de ladite seconde couche (16) d'une couche de passivation dudit troisième type (38) de manière à être contiguë à ladite couche de passivation dudit premier type (36).

12. Procédé selon la revendication 9, 10, ou 11, dans lequel ladite couche de passivation dudit premier type (31 ; 36) est appliquée à partir de l'une ou l'autre de ladite surface avant (12) et de ladite surface arrière (13), après quoi ladite couche de passivation dudit premier type (31 ; 36) est enlevée de l'une ou l'autre desdites surfaces avant (12) et arrière (13) et d'une partie de ladite structure stratifiée constituée de ladite première couche semi-conductrice (15) et ladite seconde couche semi-conductrice (16), en appliquant ensuite ladite couche de passivation dudit deuxième type (32 ; 37) de ladite surface avant (12), de manière à être contiguë à ladite couche de passivation dudit premier type (31 ; 36) et en appliquant ladite couche de passivation dudit troisième type (33 ; 38) de ladite surface arrière (13), de manière à être contiguë à ladite couche de passivation dudit premier type (31 ; 36).

13. Procédé selon la revendication 12, dans lequel l'une ou l'autre desdites couches de passivation du deuxième (32 ; 37) et/ou du troisième type (33 ; 38) est enlevée de l'une ou l'autre desdites surfaces avant (12) et arrière (13).

14. Module photovoltaïque comprenant une pluralité de dispositifs photovoltaïques connectés électriquement selon l'une quelconque des revendications 1 à 8.
